# EUROPÄISCHE PATENTANMELDUNG

(11) **EP 2 448 010 A2**
(43) Veröffentlichungstag der Anmeldung: **02.05.2012**
(21) Anmeldenummer: 11003759.5
(22) Anmeldetag: 06.05.2011
(51) Int. Cl.: H01L 31/048, H01L 31/0203, B32B 17/06, B32B 17/10

(54) **Verfahren zum Herstellen einer Randversiegelung von Photovoltaik-Modulen sowie Verwendung eines Strangkörpers hierfür, und entsprechendes Photovoltaik-Modul.**

(30) Priorität: 30.10.2010 DE 102010050187
(71) Anmelder: Robert Bürkle GmbH, 72250 Freudenstadt (DE)
(72) Erfinder: Damm, Norbert, 76689 Karlsdorf-Neuthard (DE)
(74) Vertreter: Lemcke, Brommer & Partner

(57) **Zusammenfassung**

Die vorliegende Erfindung betrifft ein Verfahren zum Herstellen eines Photovoltaikmoduls, das im wesentlichen aus transparentem Frontsubstrat, beispielsweise einem Deckglas 1, einem Rückseitensubstrat, beispielsweise einer Rückseitenfolie 6, einer dazwischen gelegten Solarzellenschicht 3 und einer wärmeaktivierbaren und hierbei erweichenden Kleberschicht 2 zum Ausbilden eines laminierten Schichtverbundes zusammengesetzt wird. Hierbei wird zur Randversiegelung des Photovoltaikmoduls ein randseitig umlaufender, die Solarzellenschicht 3 umgebender Strangkörper 7 aus oder mit einem wärmeaktivierbaren Klebermaterial 9 zwischen das Frontsubstrat 1 und das Rückseitensubstrat 6 gelegt, wobei das wärmeaktivierbare Klebermaterial 9 des Strangkörpers 7 so gewählt wird, dass es nicht oder im Vergleich zur wärmeaktivierbaren Kleberschicht 2 langsamer und/oder erst bei höheren Temperaturen erweicht oder eine im Vergleich zur wärmeaktivierbaren Kleberschicht 2 höhere Viskosität besitzt. Die Erfindung betrifft außerdem ein entsprechendes Photovoltaikmodul.

## Beschreibung

Die Erfindung betrifft ein Verfahren zum Herstellen eines Photovoltaikmoduls nach dem Oberbegriff der Ansprüche 1 und 2 sowie ein Photovoltaikmodul nach dem Oberbegriff der Ansprüche 9 und 10. Ein Photovoltaikmodul der vorliegenden Art wird im Wesentlichen aus einem transparenten Frontsubstrat, einem Rückseitensubstrat, einer dazwischengelegten Solarzellenschicht und einer wärmeaktivierbaren und hierbei erweichenden Kleberschicht zum Ausbilden eines laminierten Schichtverbundes zusammengesetzt.

Die zwischen dem Frontsubstrat, insbesondere einem Deckglas und dem Rückseitensubstrat, beispielsweise einer Rückseitenfolie oder einem Rückseitenglas befindliche Solarzellenschicht kann eine Dünnschicht-Solarzellenschicht oder eine Schicht aus einer Mehrzahl von nebeneinander angeordneten und miteinander verschalteten multi-, poly- oder monokristallinen Solarzellen sein. Die außerdem zwischen dem Frontsubstrat und dem Rückseitensubstrat vorgesehene wärmeaktivierbare Kleberschicht wird beispielsweise in Form zweier oberhalb und unterhalb der Solarzellenschicht angeordneter Kleberfolien zwischen das Frontsubstrat und das Rückseitensubstrat eingebracht. Diese Kleberfolien bestehen in der Regel aus einem transparenten thermoreaktiven Adhäsivstoff wie Ethylenvenylacetat (EVA) oder einem transparenten thermoplastischen Werkstoff.

Durch Laminieren des aus Frontsubstrat, Solarzellenschicht, Kleberschicht und Rückseitensubstrat bestehenden Schichtstapels unter Druck- und Wärmeeinwirkung entsteht aufgrund der Aktivierung der Kleberschicht ein laminierter Schichtverbund, der im wesentlichen das fertige Photovoltaikmodul ist. Die Solarzellenschicht ist nach dem Laminieren in einer klaren, dreidimensional vernetzten oder ausgehärteten, nicht mehr aufschmelzbaren Kunststoffschicht eingebettet. Mittels dieser Kunststoffschicht sind außerdem das Frontsubstrat und das Rückseitensubstrat fest miteinander verbunden, und die Solarzellen sind mitsamt ihrer Verschalung dazwischen bzw. darin fixiert. Dieser laminierte Schichtverbund stellt sicher, dass beim normalen ganzjährigen Einsatz von Photovoltaikmodulen im Freien auch langfristig nicht zu befürchten ist, dass die Solarzellenschicht mit Umgebungsfeuchte und Luftsauerstoff in Berührung kommt und hierdurch geschädigt wird.

Photovoltaikmodule mit einem Frontsubstrat, einer Solarzellenschicht und einem Rückseitensubstrat werden üblicherweise in einer Laminierpresse laminiert, wobei sie in eine bei geschlossener Presse luftdichte Kammer verbracht, dort mittels Heizplatten und dergleichen erwärmt sowie mittels einer die Kammer horizontal unterteilenden flexiblen Membran mit dem zum Laminieren notwendigen Druck beaufschlagt werden. Hierzu wird die Kammer in der Regel evakuiert, um Lufteinschlüsse in der beim Laminieren erweichenden Kleberschicht zu vermeiden sowie etwa entstehende Prozessgase und Legeluft aus dem Inneren des Schichtstapels herauszuziehen, bevor die Kleberschicht vernetzt bzw. aushärtet. Ein Beispiel für ein solches Verfahren findet sich in der DE 10 2007 025 380 A1.

Der eigentliche Laminiervorgang dauert eine gewisse Zeit, bis das Vernetzen bzw. Aushärten der Kleberschicht abgeschlossen und infolgedessen ein Wärmeeintrag in die Kleberschicht sowie in der Regel auch eine Auflast auf den Schichtverbund nicht mehr notwendig ist. Diese Zeitdauer hängt von den verwendeten Materialien ab und kann daher nicht prozesstechnisch verkürzt werden. Gleichzeitig handelt es sich beim Laminiervorgang um denjenigen Prozessschritt bei der Herstellung von Photovoltaikmodulen, der die Geschwindigkeit der gesamten Anlage limitiert. In der DE 10 2007 025 380 A1 ist daher vorgeschlagen worden, die Laminierpresse, in der die Photovoltaikmodule laminiert werden, mehretagig auszubilden, so dass jeweils mehrere Photovoltaikmodule in mehreren Pressenebenen gleichzeitig laminiert werden können.

Ein anderer Ansatz zur Beschleunigung der Herstellung von Photovoltaikmodulen der vorliegenden Art ist in der EP 1 997 614 A2 offenbart. Dort werden die Schichtstapel zunächst in einer herkömmlichen Vakuum-Laminierpresse vorlaminiert. Hierzu werden sie zur Vermeidung einer Blasenbildung unter Vakuum gesetzt, mit einer Anpresskraft beaufschlagt und sodann erwärmt, bis die Kleberschicht in einem Maße aktiviert worden ist, dass das Herausziehen von gasförmigen Bestandteilen abgeschlossen oder durch die Aktivierung der Kleberschicht zum Stillstand gekommen ist, umgekehrt jedoch auch ein Eindringen von Luft von außen in die Schichten des Photovoltaikmoduls auch bei Normaldruck ausgeschlossen ist. Zu diesem Zeitpunkt wird die Vakuum-Laminierpresse belüftet und geöffnet. Die bis hier lediglich vorlaminierten Photovoltaikmodule werden dann in eine zweite Laminierpresse (ohne Vakuum) verbracht, um dort unter Auflast weiterhin Wärme in den Schichtverbund einzubringen, bis das Vernetzen der Kleberschicht bzw. deren Aushärten abgeschlossen ist. Nach diesem Stand der Technik wird der Laminierprozess also in zwei Teilprozesse bzw. Arbeitstakte geteilt, so dass die Durchsatzleistung der Laminierpresse und damit der gesamten Anlage zur Herstellung von Photovoltaikmodulen verdoppelt wird.

Die zum Laminieren von Photovoltaikmodulen verwendeten Klebermaterialien besitzen in aller Regel hochadhäsive Eigenschaften, sobald sie aktiviert werden. Dies gilt insbesondere im erweichten, jedoch noch nicht vernetzten bzw. ausgehärteten Zustand. Da das Laminieren nicht nur durch Wärmeeintrag in den Schichtverbund, sondern auch durch Einwirken einer Auflast auf den Schichtverbund erfolgt, besteht immer die Gefahr, dass Material der erweichten Kleberschicht randseitig zwischen dem Frontsubstrat, beispielsweise einem Deckglas und dem Rückseitensubstrat, insbesondere einer Rückseitenfolie austritt, also mehr oder weniger zwischen diesen Schichten seitlich herausgequetscht wird. Dieses Material ist, wie erwähnt, jedoch hochadhäsiv, woraus sich hartnäckige Verschmutzungen der Laminierpresse und dort insbesondere der flexiblen Membran oder eines verwendeten Förderbandes ergeben. Solche Verschmutzungen limitieren nicht nur die Lebensdauer der verschmutzten Teile, sondern können gegebenenfalls zur Produktion von Ausschuss bei den nachfolgend prozessierten Photovoltaikmodulen führen.

Besondere Relevanz erhält diese Problematik beim oben beschrieben Kurztaktverfahren, das in der EP 1 997 614 A2 offenbart ist. Denn dort werden die vorlaminierten Photovoltaikmodule mit bis zum flüssigen Zustand erweichten Kleberschichten von der ersten Laminierstation in die zweite Laminierstation transportiert, so dass etwa in der ersten Station seitlich aus den Modulen herausgedrückter Kleber auch auf dem Transportweg sowie in der zweiten Laminierstation Probleme bereitet.

Der vorliegenden Erfindung liegt daher die Aufgabe zugrunde, ein Verfahren zum Herstellen eines Photovoltaikmoduls der eingangs genannten Art sowie ein mit diesem Verfahren herstellbares Photovoltaikmodul vorzuschlagen, bei dem die Gefahr zumindest deutlich vermindert ist, dass beim Laminierprozess unbeabsichtigt Material der wärmeaktivierbaren Kleberschicht randseitig zwischen dem Frontsubstrat und dem Rückseitensubstrat austritt.

Gelöst ist diese Aufgabe durch ein Verfahren mit den Merkmalen des Anspruchs 1 und durch ein Verfahren mit den Merkmalen des Anspruchs 2 sowie durch ein Photovoltaikmodul mit den Merkmalen des Anspruchs 9 und ein Photovoltaik-modul mit den Merkmalen des Anspruchs 10. Vorteilhafte Weiterbildungen der erfindungsgemäßen Verfahren finden sich in den Ansprüchen 3 bis 8; bevorzugte Ausgestaltungen der erfindungsgemäßen Photovoltaikmodule sind in den Ansprüchen 11 bis 16 niedergelegt.

Nach der vorliegenden Erfindung wird das Photovoltaikmodul demnach mit einer Randversiegelung versehen, die durch einen randseitig umlaufenden, die Solarzellenschicht umgebenden Strangkörper zwischen dem Frontsubstrat und dem Rückseitensubstrat gebildet ist. Dieser Strangkörper bildet wie erwähnt eine Randversiegelung und damit eine Barriere gegen ein randseitiges Austreten der erweichten und gegebenenfalls sogar verflüssigten Kleberschicht beim Laminieren. Damit der Strangkörper eine solche Barrierewirkung hervorrufen kann, besteht er ebenfalls zumindest zum Teil aus einem wärmeaktivierbaren Klebermaterial, so dass er sich beim Laminieren sowohl einerseits mit dem Frontsubstrat als auch andererseits mit dem Rückseitensubstrat verbindet und so zuverlässig verhindert, dass Material von der wärmeaktivierbaren Kleberschicht aus dem Inneren des Schichtverbundes nach außen treten kann. Gleichzeitig wird erfindungsgemäß sichergestellt, dass das wärmeaktivierbare Klebermaterial des Strangkörpers entweder nicht oder im Vergleich zur wärmeaktivierbaren Kleberschicht langsamer und/oder erst bei höheren Temperaturen erweicht, oder aber dass das wärmeaktivierbare Klebermaterial des Strangkörpers im Vergleich zur wärmeaktivierbaren Kleberschicht bei gleicher Temperatur eine höhere Viskosität besitzt. Somit ist selbst dann, wenn die eigentliche wärmeaktivierbare Kleberschicht des Photovoltaikmoduls in einen sehr weichen oder sogar flüssigen Zustand gerät, die Barrierewirkung des umgebenden Strangkörpers aufgrund seiner geringeren Erweichung oder aufgrund seiner höheren Viskosität sichergestellt.

Um beiden Anforderungen an den Strangkörper optimal entsprechen zu können, also eine hohe Adhäsionswirkung gegen einerseits das Frontsubstrat und andererseits das Rückseitensubstrat bereitzustellen und dennoch eine höhere Stabilität durch geringere Erweichung oder höhere Viskosität als die wärmeaktivierbare Kleberschicht und somit eine Barrierewirkung sicherzustellen, kann nach einer bevorzugten Weiterbildung der vorliegenden Erfindung der Strangkörper aus einem Kern und einer diesen einhüllenden Mantelschicht aus wärmeaktivierbarem Klebermaterial zusammengesetzt sein. Der Kern ist dann für die Stabilität und die damit zusammenhängende Barrierewirkung zuständig, während die Mantelschicht mit einer besonders hohen und früh einsetzenden Adhäsionswirkung versehen sein kann. Beispielsweise kann die Mantelschicht aus einem Polyisobutyl-Werkstoff oder einem Epoxidharz bestehen. Der Kern kann beispielsweise aus einem strangpressbaren, wenig nachgiebigen Material, wie einen temperaturstabilen Kunststoff oder einem Metall, insbesondere Kupfer, Aluminium oder Zinn bestehen.

Eine andere bevorzugte Ausgestaltung der vorliegenden Erfindung besteht darin, dass als wärmeaktivierbares Klebermaterial für den Strangkörper dasjenige Material verwendet wird, aus dem auch die wärmeaktivierbare Kleberschicht des Schichtverbundes besteht. Um hierbei die erfindungsgemäßen Unterschiede zwischen dem randversiegelnden Strangkörper und der innenliegenden Kleberschicht zu erzielen, kann dieses Klebermaterial mit Beimischungen versehen werden, die die Aktivierbarkeit, die Adhäsionswirkung und/oder die Viskosität des Materials beeinflussen. Dies ist besonders gut bei thermoplastischen Elastomeren umzusetzen, deren Viskosität durch Beimischungen gezielt veränderbar ist. Jedoch auch andere Materialien für die Kleberschicht, wie beispielsweise EVA, TPO, TPU, PVB und lonomer können auf diese Art und Weise zusätzlich als Strangkörper im Sinne der vorliegenden Erfindung verwendet werden. Neben den Vorteilen der chemischen Verträglichkeit mit der Kleberschicht und denselben verwitterungsbeständigen Eigenschaften ergibt sich hierbei außerdem der Vorteil, dass der Strangkörper zur Randversiegelung ebenso transparent ist, wie die eigentliche Kleberschicht, also zum einen im fertigen Photovoltaikmodul unsichtbar ist, und zum anderen die Lichteinstrahlung in das Photovoltaikmodul nicht stört.

Um bei identischem Material für die wärmeaktivierbare Kleberschicht und das wärmeaktivierbare Klebermaterial des Strangkörpers die erfindungsgemäßen Unterschiede zwischen dem Strangkörper und der innenliegenden Kleberschicht ohne Beimischungen zu erzielen, kann im Rahmen der vorliegenden Erfindung alternativ vorgesehen sein, als wärmeaktivierbares Klebermaterial des Strangkörpers das Material der wärmeaktivierbaren Kleberschicht mit einer höheren Schichtdicke zu verwenden. Hierbei sollte diese höhere Schichtdicke dem 1,1-fachen bis 3-fachen, vorzugsweise dem 1,2-fachen bis 1,5-fachen der Schichtdicke der innenliegenden Kleberschicht entsprechen. Durch die randseitige Materialanhäufung ergibt sich bei geeigneten Klebermaterialien die gewünschte Barrierewirkung, da das aufgedickte Material langsamer erweicht und insofern bei geeigneter Wahl der Prozessparameter eine höhere Viskosität aufweist als die innenliegende Kleberschicht.

Im Rahmen der vorliegenden Erfindung sind selbstverständlich auch andere Materialien für den erfindungsgemäßen Strangkörper einsetzbar, wie beispielsweise lonomer-Barriere-Material, PU-Hotmelt, Materialien auf Basis von TPS und PIV (Polyisobutylen), aufgeschäumte thermoplastische Elastomere und dergleichen.

Erfindungsgemäße Photovoltaikmodule besitzen vorzugsweise als Frontsubstrat ein Deckglas und als Rückseitensubstrat eine Rückseitenfolie. Hierauf ist die vorliegende Erfindung jedoch nicht beschränkt; sie umfasst vielmehr auch Photovoltaikmodule und Verfahren zur Herstellung eines solchen, die mit einem Deckglas und einem Rückseitenglas versehen oder mit einer transparenten Deckfolie und einer Rückseitenfolie aufgebaut sind. Die Erfindung eignet sich also für alle bekannten Arten von Photovoltaikmodulen: Glas-Glas-Module, Glas-Folien-Module und Folien-Folien-Module. Auch andere Substratkombinationen sind denkbar und von der vorliegenden Erfindung umfasst, beispielsweise ein Modul mit einer Deckfolie und einem Rückseitenglas, oder ein Modul mit einer nicht aus Glas bestehenden Rückseitenplatte und einem Deckglas oder einer Deckfolie.

Ein Ausführungsbeispiel für ein erfindungsgemäß ausgestaltetes Verfahren zum Herstellen eines Photovoltaikmoduls wird im folgenden anhand der beigefügten Zeichnungen näher beschrieben und erläutert. Es zeigen:
Figur 1 einen schematischen Schnitt durch ein Photovoltaikmodul mit Deckglas und Rückseitenfolie in einer ersten Montagephase;
Figur 2 den Schnitt aus Figur 1 in einer zweiten Montagephase.

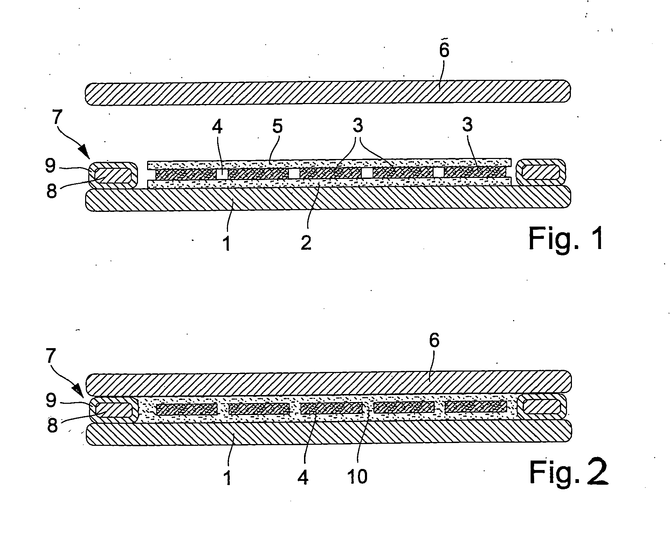

Figur 1 zeigt eine erste und Figur 2 eine zweite Phase des Herstellens eines Photovoltaik-Moduls und im Besonderen des Herstellens einer ersten Ausführung einer erfindungsgemäßen Randversiegelung in schematischen Querschnittsdarstellungen. In Figur 1 wurde ein Deckglas 1 auf einen (nicht dargestellten) Legetisch gelegt und darauf eine erste wärmeaktivierbare Kleberschicht 2 in Form einer EVA-Folie aufgelegt. Auf diese erste Kleberschicht 2 wurden sodann eine Anzahl von Solarzellen 3 aufgelegt und mittels (nicht dargestellter) Lötbändchen elektrisch miteinander verschaltet, um eine Solarzellenschicht 4 zu bilden. Auf diese Solarzellenschicht 4 wurde schließlich eine zweite EVA-Folie als weitere Kleberschicht 5 gelegt.

Bevor nun eine Rückseitenfolie 6 auf die Solarzellenschicht 4 bzw. die zweite Kleberschicht 5 aufgelegt wird, wird erfindungsgemäß rund um die Solarzellenschicht 4 und die beiden Kleberschichten 2, 5 umlaufend ein Strangkörper 7 auf den Randbereich des Deckglases 1 aufgebracht, wobei dieser Strangkörper 7 hier aus einem innenliegenden Kern 8, der mechanisch wenig nachgiebig ist, und einer diesen Kern 8 umgebenden Mantelschicht 9 besteht. Die Mantelschicht 9 besteht aus einem wärmeaktivierbar adhäsiven, unter Wärmeeinwirkung viskosen Material.

Figur 2 zeigt das fertig laminierte Photovoltaik-Modul, bestehend aus dem Deckglas 1, der in einer transparenten und vernetzten Kleberschicht 10 eingebetteten Solarzellenschicht 4, der Rückseitenfolie 6 und der aus dem Strangkörper 7 mit Kern 8 und Mantelschicht 9 gebildeten Randversiegelung. Der Kern 8 des Strangkörpers 7 besteht aus einem Heißkleber, dessen rheologische Eigenschaften so beschaffen sind, dass während der thermischen Prozessphasen des Laminierens eine ständig höhere Viskosität als in den Kleberschichten 2, 5 vorliegt. Die Mantelschicht 9 des Strangkörpers 7 besteht aus Isobutyl.

Bei einem Versuch an einem in den Figuren 1 und 2 dargestellten Photovoltaik-modul mit den dargestellten Verfahrensschritten wurde beim Laminiervorgang oder danach kein nennenswerter Austritt von adhäsivem Material aus den Rändern des Photovoltaikmoduls festgestellt. Eine nachteilige Verschmutzung der Laminierpresse bzw. von deren Fördereinrichtungen mit adhäsiven Stoffen konnte also effektiv verhindert werden.

## Patentansprüche

1. Verfahren zum Herstellen eines Photovoltaikmoduls, das im wesentlichen aus einem transparenten Frontsubstrat (1), einem Rückseitensubstrat (6), einer dazwischen gelegten Solarzellenschicht (3) und einer wärmeaktivierbaren und hierbei erweichenden Kleberschicht (2) zum Ausbilden eines laminierten Schichtverbundes zusammengesetzt wird,
**dadurch gekennzeichnet,**
**dass** zur Randversiegelung des Photovoltaikmoduls ein randseitig umlaufender, die Solarzellenschicht (3) umgebender Strangkörper (7) aus oder mit einem wärmeaktivierbaren Klebermaterial (9) zwischen das Frontsubstrat (1) und das Rückseitensubstrat (6) gelegt wird, wobei das wärmeaktivierbare Klebermaterial (9) des Strangkörpers (7) qualitativ und/oder quantitativ so gewählt wird, dass es nicht oder im Vergleich zur wärmeaktivierbaren Kleberschicht (2) langsamer und/oder erst bei höheren Temperaturen erweicht.

2. Verfahren zum Herstellen eines Photovoltaikmoduls, das im wesentlichen aus einem transparenten Frontsubstrat (1), einem Rückseitensubstrat (6), einer dazwischen gelegten Solarzellenschicht (3) und einer wärmeaktivierbaren und hierbei erweichenden Kleberschicht (2) zum Ausbilden eines laminierten Schichtverbundes zusammengesetzt wird,
**dadurch gekennzeichnet,**
**dass** zur Randversiegelung des Photovoltaikmoduls ein randseitig umlaufender, die Solarzellenschicht (3) umgebender Strangkörper (7) aus oder mit einem wärmeaktivierbaren Klebermaterial (9) zwischen das Frontsubstrat (1) und das Rückseitensubstrat (6) gelegt wird, wobei das wärmeaktivierbare Klebermaterial (9) des Strangkörpers (7) so gewählt wird, dass es bei den zum Aktivieren der Kleberschicht (2) verwendeten Temperaturen eine im Vergleich zur wärmeaktivierbaren Kleberschicht (2) höhere Viskosität besitzt.

3. Verfahren nach einem der Ansprüche 1 oder 2,
**dadurch gekennzeichnet,**
**dass** als wärmeaktivierbares Klebermaterial (9) das Material der wärmeaktivierbaren Kleberschicht (2) mit Beimischungen verwendet wird, welche die Aktivierbarkeit, die Adhäsionswirkung und/oder die Viskosität beeinflussen.

4. Verfahren nach einem der Ansprüche 1 oder 2,
**dadurch gekennzeichnet,**
**dass** als wärmeaktivierbares Klebermaterial (9) das Material der wärmeaktivierbaren Kleberschicht (2) mit einer höheren Schichtdicke verwendet wird.

5. Verfahren nach Anspruch 4,
**dadurch gekennzeichnet,**
**dass** ein Strangkörper (7) aus oder mit einem wärmeaktivierbaren Klebermaterial (9) verwendet wird, dessen Schichtdicke dem 1,1-fachen bis 3-fachen, vorzugsweise dem 1,2-fachen bis 1,5-fachen der Schichtdicke der wärmeaktivierbaren Kleberschicht (2) entspricht.

6. Verfahren nach mindestens einem der Ansprüche 1 bis 5,
**dadurch gekennzeichnet,**
**dass** ein Strangkörper (7) verwendet wird, der aus einem Kern (8) und einer diesen einhüllenden Mantelschicht (9) aus wärmeaktivierbarem Klebermaterial besteht.

7. Verfahren nach mindestens einem der Ansprüche 1 bis 6,
**dadurch gekennzeichnet,**
**dass** die Kleberschicht (2) des Photovoltaikmoduls in einer ersten Laminierpresse nur so weit aktiviert und erweicht wird, bis die Solarzellenschicht (3) im Schichtverbund gegen die Umgebung verkapselt ist, und dass das Photovoltaikmodul dann von der ersten Laminierpresse zum weiteren Prozessieren in einen zweiten Laminator verbracht wird.

8. Verfahren nach mindestens einem der Ansprüche 1 bis 7,
**dadurch gekennzeichnet,**
**dass** als Frontsubstrat ein Deckglas (1) und als Rückseitensubstrat eine Rückseitenfolie (6) verwendet wird.

9. Photovoltaikmodul, insbesondere hergestellt in einem Verfahren nach einem der Ansprüche 1 bis 8, mit einem transparenten Frontsubstrat (1), einem Rückseitensubstrat (6), einer dazwischen gelegten Solarzellenschicht (3) und einer zum Ausbilden eines laminierten Schichtverbundes wärmeaktivierbaren und hierbei erweichenden Kleberschicht (2),
**dadurch gekennzeichnet,**
**dass** zwischen dem Frontsubstrat (1) und dem Rückseitensubstrat (6) ein randseitig umlaufender, die Solarzellenschicht (3) umgebender Strangkörper (7) aus oder mit einem wärmeaktivierbaren Klebermaterial (9) vorhanden ist, das nicht oder im Vergleich zur wärmeaktivierbaren Kleberschicht (2) langsamer und/oder erst bei höheren Temperaturen erweicht.

10. Photovoltaikmodul, insbesondere hergestellt in einem Verfahren nach einem der Ansprüche 1 bis 8, mit einem transparenten Frontsubstrat (1), einem Rückseitensubstrat (6), einer dazwischen gelegten Solarzellenschicht (3) und einer zum Ausbilden eines laminierten Schichtverbundes wärmeaktivierbaren und hierbei erweichenden Kleberschicht (2),
**dadurch gekennzeichnet,**
**dass** zwischen dem Frontsubstrat (1) und dem Rückseitensubstrat (6) ein randseitig umlaufender, die Solarzellenschicht (3) umgebender Strangkörper (7) aus oder mit einem wärmeaktivierbaren Klebermaterial (9) vorhanden ist, das bei den zum Aktivieren der Kleberschicht (2) verwendeten Temperaturen eine im Vergleich zur wärmeaktivierbaren Kleberschicht (2) höhere Viskosität besitzt.

11. Photovoltaikmodul nach einem der Ansprüche 9 oder 10,
**dadurch gekennzeichnet,**
**dass** das wärmeaktivierbare Klebermaterial (9) aus dem Material der wärmeaktivierbaren Kleberschicht (2) mit Beimischungen besteht, welche die Aktivierbarkeit, die Adhäsionswirkung und/oder die Viskosität beeinflussen.

12. Photovoltaikmodul nach einem der Ansprüche 9 oder 10,
**dadurch gekennzeichnet,**
**dass** das wärmeaktivierbare Klebermaterial (9) aus dem Material der wärmeaktivierbaren Kleberschicht (2) mit einer höheren Schichtdicke besteht.

13. Photovoltaikmodul nach Anspruch 12,
**dadurch gekennzeichnet,**
**dass** die Schichtdicke des wärmeaktivierbaren Klebermaterials (9) dem 1,1-fachen bis 3-fachen, vorzugsweise dem 1,2-fachen bis 1,5-fachen der Schichtdicke der wärmeaktivierbaren Kleberschicht (2) entspricht.

14. Photovoltaikmodul nach mindestens einem der Ansprüche 9 bis 13,
**dadurch gekennzeichnet,**
**dass** der Strangkörper (7) aus einem Kern (8) und einer diesen einhüllenden Mantelschicht (9) aus wärmeaktivierbarem Klebermaterial besteht.

15. Photovoltaikmodul nach mindestens einem der Ansprüche 9 bis 14,
**dadurch gekennzeichnet,**
**dass** der Strangkörper (7) zumindest teilweise aus einem thermoplastischen. Elastomer besteht.

16. Photovoltaikmodul nach mindestens einem der Ansprüche 9 bis 15,
**dadurch gekennzeichnet,**
**dass** das Frontsubstrat ein Deckglas (1) und das Rückseitensubstrat eine Rückseitenfolie (6) ist.
